# FASCICULE DE BREVET EUROPEEN

(11) **EP 2 737 541 B1**
(45) Date de publication et mention de la délivrance du brevet: **26.08.2015**
(21) Numéro de dépôt: 12740969.6
(22) Date de dépôt: 27.07.2012
(51) Int. Cl.: H02S 40/36

(54) **MODULE PHOTOVOLTAIQUE AVEC LIAISON SIMPLIFIEE**
PHOTOVOLTAIKMODUL MIT VEREINFACHTEM ANSCHLUSS
PHOTOVOLTAIC MODULE WITH SIMPLIFIED CONNECTION

(30) Priorité: 29.07.2011 FR 1157003
(43) Date de publication de la demande: 04.06.2014
(73) Titulaire: Commissariat à l'Énergie Atomique et aux Énergies Alternatives, 75015 Paris (FR)
(72) Inventeur: CHAINTREUIL, Nicolas, F-73800 Montmelian (FR); MESSAOUDI, Paul, F-73230 Saint-Alban Leysse (FR); PILAT, Eric, F-73100 Brison-Saint-Innocent (FR)
(74) Mandataire: Novaimo
(86) Numéro de dépôt international: PCT/EP2012/064786
(87) Numéro de publication internationale: WO 2013/017541

(56) Documents cités:
- EP-A1- 0 373 235
- DE-A1- 4 140 682
- DE-A1-102005 050 883
- JP-A- 58 063 181

## Description

L'invention concerne un module photovoltaïque, un dispositif photovoltaïque et une installation de production d'électricité photovoltaïque comprenant plusieurs de ces modules photovoltaïques.

L'installation d'un dispositif photovoltaïque nécessite aujourd'hui un câblage complexe de différents modules entre eux, pour former un ensemble électriquement connecté. Ces connexions électriques consistent par exemple à relier différents modules en série, avant de les relier à un onduleur. Ces connexions nécessitent la liaison électrique de modules adjacents par la liaison de leurs bornes respectives situées dans une boîte de jonction placée au niveau de leur face arrière. La méthode de connexion de l'état de la technique nécessite des sertissages de connecteurs dans la pratique. Il en ressort les inconvénients suivants :
- l'installation d'un dispositif photovoltaïque est longue et coûteuse ;
- le dispositif photovoltaïque obtenu présente un risque d'anomalie, de vieillissement prématuré, voire d'accident suite à un arc électrique, si une connexion est mal réalisée du fait par exemple d'un mauvais sertissage. Il en résulte un manque de fiabilité d'un tel dispositif.

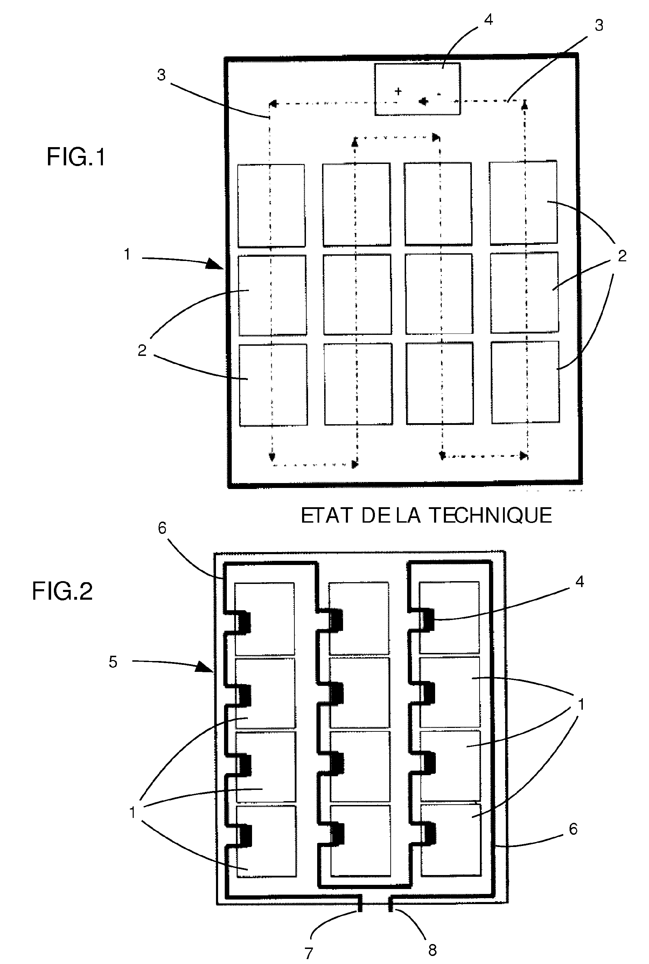

A titre d'exemple, la figure 1 représente schématiquement un module photovoltaïque 1 traditionnel, selon l'état de la technique. Ce module 1 rectangulaire comprend plusieurs cellules 2 reliées entre elles en série par des câbles 3. Les deux extrémités de cette liaison électrique forment les deux pôles positif et négatif du module, accessibles par un connecteur électrique aménagé dans une boîte de jonction 4 disposée au niveau de la face arrière du module. Un tel module photovoltaïque 1 représente un élément de base d'un dispositif photovoltaïque, qui est généralement construit par une association de plusieurs modules photovoltaïques.

A titre d'exemple, la figure 2 représente un dispositif photovoltaïque traditionnel, comprenant un assemblage de douze modules photovoltaïques 1 disposés en trois colonnes et connectés électriquement en série par des câbles 6 reliant leurs boîtes de jonction 4 pour former une liaison électrique entre les deux bornes 7, 8 de sortie du dispositif.

Le document WO2008136872 décrit un module photovoltaïque particulier comprenant une boîte de connexion pour chaque pôle positif et négatif, disposée sur un côté du module. Cette approche se distingue de la solution traditionnelle décrite ci-dessus sans toutefois réussir à simplifier réellement l'assemblage de plusieurs modules, car cette solution reste peu flexible. D'autre part, les connectiques proposées conservent les risques mentionnés précédemment.

Le document WO2009063855 décrit un module photovoltaïque comprenant de même deux pôles positif et négatif positionnés sur deux côtés opposés du module. Cette solution conserve les mêmes inconvénients que la précédente.

D'autres solutions comme celles décrites dans les documents DE4140682, JP58063181, DE102005050883, tentent d'améliorer les précédentes, tout en restant insatisfaisantes.

Ainsi, un objet général de l'invention est de proposer une solution permettant une installation d'un dispositif photovoltaïque qui réduit les inconvénients des solutions de l'état de la technique.

Plus précisément, l'invention cherche à atteindre tout ou partie des objets suivants :

Un premier objet de l'invention est de proposer une solution de réalisation d'un dispositif photovoltaïque qui ne comprend pas les risques liés aux connectiques de l'état de la technique.

Un second objet de l'invention est de proposer une solution de réalisation d'un dispositif photovoltaïque qui simplifie l'assemblage mécanique et/ou électrique de plusieurs modules photovoltaïques entre eux.

A cet effet, l'invention repose sur un module photovoltaïque comprenant plusieurs cellules photovoltaïques reliées électriquement, caractérisé en ce qu'il présente une forme carrée et comprend au moins deux plots de connexion dans chaque angle du module de sorte à comprendre au moins quatre connecteurs sur chaque côté du module.

L'invention est plus précisément définie par les revendications.

Le module photovoltaïque peut comprendre un câble reliant toutes les cellules, comprenant une première extrémité liée à un premier plot de connexion de polarité positive au niveau d'un côté du module, traversant un second plot de connexion de même polarité au niveau d'un second côté adjacent, puis toutes les cellules du module pour les relier électriquement en série, puis traversant un troisième plot de connexion de polarité négative au niveau d'un troisième côté, avant d'atteindre un quatrième plot de connexion au niveau d'un quatrième côté.

Selon une variante, le module photovoltaïque peut comprendre des câbles reliant toutes les cellules, comprenant une première extrémité liée à un premier plot de connexion de polarité positive au niveau d'un côté du module, traversant un second plot de connexion de même polarité au niveau d'un second côté adjacent, puis toutes les cellules du module pour les relier électriquement en série et en parallèle, puis traversant un troisième plot de connexion de polarité négative au niveau d'un troisième côté, avant d'atteindre un quatrième plot de connexion au niveau d'un quatrième côté.

L'invention porte aussi sur un dispositif photovoltaïque, caractérisé en ce qu'il comprend plusieurs modules photovoltaïques tels que décrits précédemment reliés mécaniquement et électriquement.

L'invention porte aussi sur une installation de production d'électricité photovoltaïque, caractérisée en ce qu'elle comprend plusieurs dispositifs photovoltaïques tels que décrits ci-dessus.

Ces objets, caractéristiques et avantages de la présente invention seront exposés en détail dans la description suivante d'un mode d'exécution particulier fait à titre non-limitatif en relation avec les figures jointes parmi lesquelles :
La figure 1 illustre schématiquement un module photovoltaïque selon l'état de la technique.
La figure 2 représente schématiquement un dispositif photovoltaïque selon l'état de la technique.
La figure 3 représente schématiquement un module photovoltaïque selon un mode de réalisation de l'invention.
La figure 4 représente une vue en coupe de côté d'une partie de la structure multicouche d'un module photovoltaïque selon un mode de réalisation de l'invention.
Les figures 5 à 7 représentent schématiquement des dispositifs photovoltaïques comprenant des modules photovoltaïques selon le mode de réalisation de l'invention.

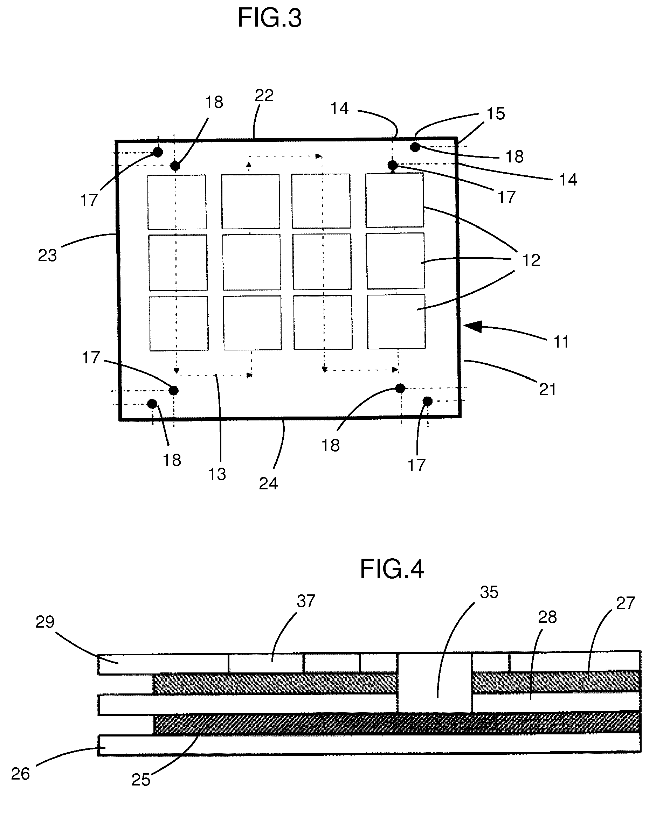

La figure 3 représente un mode de réalisation d'un module photovoltaïque 11, qui comprend des cellules 12 intégrées dans un laminé, comme dans la solution traditionnelle de l'état de la technique représentée sur la figure 1, mais agencées dans un cadre dont le contour extérieur est carré. Nous dirons plus simplement que le module est de forme carrée. Les différentes cellules 12 sont reliées entre elles en série par un câble 13. En variante non représentée, elles pourraient être reliées de manière matricielle par des câblages 13.

Le module 11 comprend des connecteurs 14, 15, agencés vers les angles du module. En effet, deux plots de connexion 17, 18, respectivement de polarité positive et négative, sont aménagés au voisinage de chaque angle du module. Chaque plot de connexion 17, 18 est relié à deux connecteurs 14, 15 répartis au niveau des deux côtés adjacents du module disposés autour de cet angle où se trouvent agencés les plots de connexion. Ainsi, chaque côté 21, 22, 23, 24 du module comprend quatre connecteurs, deux de chaque polarité. Cette réalisation offre ainsi une multitude de possibilité de connexions électriques, ce qui facilite la réalisation des assemblages de modules.

En remarque, pour obtenir ces différents plots de connexion 17, 18 à plusieurs endroits sur le pourtour du module, une solution, représentée sur la figure 4, repose sur la réalisation de conducteurs sur des couches isolantes et sur l'empilement de telles couches. Pour cela, les techniques utilisées pour la fabrication de circuits intégrés peuvent être mises en oeuvre, pour former des conducteurs en cuivre ou aluminium par exemple, gravés sur des couches isolantes comprenant un polymère de type PET, époxy ou polyamide par exemple, pour former un ensemble multicouche. La figure 4 illustre ainsi schématiquement un exemple dans lequel un premier conducteur 25 est formé par métallisation sur une première couche isolante 26, et un second conducteur 27 est formé sur une seconde couche isolante 28, superposée à la première. Une dernière couche isolante 29 recouvre l'ensemble. Dans cet ensemble, un premier évidement 35 est réalisé dans cette structure, en superposition avec le premier conducteur 25, pour permettre une prise de liaison avec ce conducteur. Cet évidement traverse donc la couche isolante de surface 29 ainsi que la seconde couche isolante 28 comprenant le second conducteur 27. Un second évidement 37 est réalisé dans la seule couche isolante 29 de surface pour permettre une liaison électrique avec le second conducteur 27. En variante, des fils ou rubans entourés de gaines isolantes peuvent se croiser dans l'épaisseur du module, sans risque de court-circuit, pour atteindre les différents connecteurs périphériques.

Ainsi, dans cette réalisation, on peut utiliser un laminé multicouche dans lequel sont superposées des bandes conductrices (d'épaisseur entre 100 et 300 pm inclus), intercalées par des couches isolantes (en matériau PET, PVF,...). La prise de contact se fait par divers type de connecteurs, soudés ou contact par ressort.

En variante, cette réalisation peut être obtenue par des plans équipotentiels réalisés par dépôt électrochimique ou électrolytique (d'épaisseur entre 10-100µm) : une dalle rigide (verre, époxy fibré, PET,...) est par exemple recouverte sur ses deux faces par un métal conducteur, par exemple en cuivre ou aluminium flexible, chacune des faces représentant une polarité. La réalisation d'un contact est ensuite obtenue en soudant un ruban conducteur dans les angles.

Il apparaît de plus que les différentes cellules d'un module peuvent être liées entre elles par des câblages différents selon les différentes implémentations représentées à titre d'exemple, de manière non limitative. Une liaison de type série présente l'avantage de maximiser la tension de sortie du module. Une liaison de type parallèle permet l'équilibrage automatique des courants, par exemple lorsque les cellules ne sont pas éclairées de façon identique.

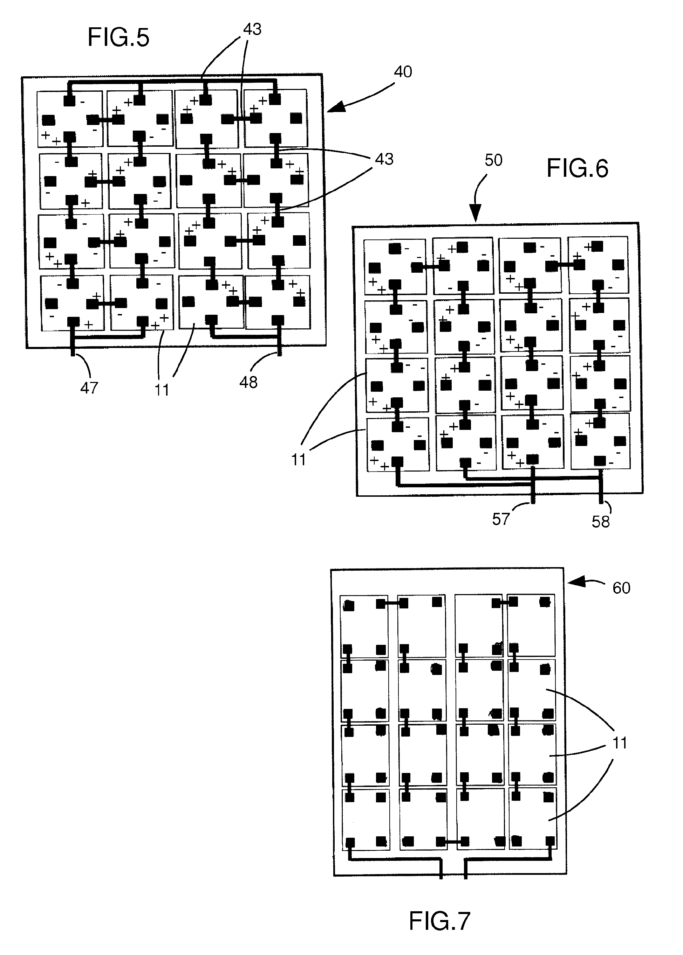

La figure 5 représente une première implémentation du module selon le mode de réalisation. Seize modules 11 sont reliés entre eux par des connexions électriques 43 pour former un dispositif photovoltaïque 40. Le câblage de ces modules est tel qu'il forme une liaison selon une architecture de type matricielle entre les deux bornes de sortie 47, 48 du dispositif.

La figure 6 représente une seconde implémentation, comprenant toujours seize modules agencés selon le même assemblage mécanique, regroupés sous la forme de deux chaînes de huit modules 11 connectés en série, ces deux chaînes se trouvant disposées en parallèle entre les deux bornes de sortie 57, 58 du dispositif photovoltaïque 50.

En remarque, pour une raison de simplification de la lecture, les contacts 14, 15 agencés sur les côtés des modules 11 ne sont pas tous représentés. D'autre part, ceux représentés sont positionnés au centre des côtés, mais ils pourraient être plus proches d'un angle.

La figure 7 représente une implémentation d'un module 11 selon ce mode de réalisation pour former un dispositif photovoltaïque 60 formé par un ensemble de seize modules 11 connectés électriquement en série et reliés mécaniquement en quatre colonnes de quatre modules pour former un ensemble carré compact, d'encombrement minimum, comme dans les deux réalisations représentées par les figures 5 et 6. En remarque, ce dispositif compact occupe le même encombrement que le dispositif de l'état de la technique représenté sur la figure 2, reportée à côté de la figure 7 pour faciliter la comparaison. Ce gain en volume est obtenu par la forte simplification et réduction du câblage, comme cela apparaît de manière explicite sur la figure, grâce à la nouvelle architecture des modules selon l'invention.

Ainsi, l'approche précédente permet de faciliter et d'assouplir l'assemblage mécanique des modules, qui peuvent être regroupés à proximité les uns des autres pour former des ensembles de géométrie carrée, voire rectangulaire, voire de toute autre forme. De plus, le positionnement des connecteurs électriques permet un large choix pour réaliser la connexion entre les différents modules, de type en série, et/ou parallèle, ou matricielle. Cette approche permet ainsi de minimiser l'encombrement global des ensembles de modules, tout en simplifiant leur liaison électrique, en réduisant le coût et augmentant leur fiabilité.

## Revendications

1. Module photovoltaïque (11) comprenant plusieurs cellules (12) photovoltaïques reliées électriquement, dit module comprénant une forme carrée et comprenant au moins deux plots de connexion (17, 18) dans chaque angle du module, **caractérisé en ce qu'**il comprend au moins quatre connecteurs (14, 15) sur chaque côté (21 ; 22 ; 23 ; 24) du module.

2. Module photovoltaïque (11) selon la revendication précédente, **caractérisé en ce qu'**il comprend une liaison électrique par au moins un conducteur (25 ; 27) gravé dans des couches isolantes (26 ; 28) de la structure multicouche du module et au moins un évidement (35 ; 37) pour permettre une connexion avec ce au moins un conducteur (25 ; 27).

3. Module photovoltaïque (11) selon la revendication 1, **caractérisé en ce qu'**il comprend des plans équipotentiels réalisés par dépôt électrochimique ou électrolytique, une dalle rigide comme en verre, ou époxy fibré, ou PET, étant recouverte sur ses deux faces par un métal conducteur, comme en cuivre ou aluminium flexible, chacune des faces représentant une polarité.

4. Module photovoltaïque (11) selon l'une des revendications précédentes, **caractérisé en ce qu'**il comprend une liaison électrique par au moins un ruban conducteur isolé disposé dans l'épaisseur du module.

5. Module photovoltaïque (11) selon l'une des revendications précédentes, **caractérisé en ce qu'**il comprend plusieurs connecteurs de polarité positive et négative aménagés au niveau de son pourtour carré, sans fil sortant du module.

6. Dispositif photovoltaïque, **caractérisé en ce qu'**il comprend plusieurs modules photovoltaïques (11) selon l'une des revendications précédentes reliés mécaniquement et électriquement.

7. Dispositif photovoltaïque selon la revendication précédente, **caractérisé en ce qu'**il comprend plusieurs modules photovoltaïques (11) reliés selon un ensemble formant un rectangle ou un carré, et **en ce que** les modules sont reliés en série ou en parallèle ou selon une structure matricielle.

8. Installation de production d'électricité photovoltaïque, **caractérisée en ce qu'**elle comprend plusieurs dispositifs photovoltaïques selon la revendication 6 ou 7.

## Patentansprüche

1. Photovoltaikmodul (11), umfassend mehrere Photovoltaikzellen (12), die elektrisch verbunden sind, wobei das Modul eine quadratische Form aufweist und mindestens zwei Anschlusspunkte (17, 18) in jedem Winkel des Moduls umfasst, **dadurch gekennzeichnet, dass** es mindestens vier Stecker (14, 15) auf jeder Seite (21; 22; 23; 24) des Moduls umfasst.

2. Photovoltaikmodul (11) nach dem vorhergehenden Anspruch, **dadurch gekennzeichnet, dass** es einen elektrischen Anschluss durch mindestens einen Leiter (25; 27), der in Isolierschichten (26; 28) der mehrschichtigen Struktur des Moduls graviert ist, und mindestens eine Ausnehmung (35; 37) umfasst, um einen Anschluss mit diesem mindestens einen Leiter (25; 27) zu ermöglichen.

3. Photovoltaikmodul (11) nach Anspruch 1, **dadurch gekennzeichnet, dass** es Äquipotentialflächen umfasst, die durch elektrochemische oder elektrolytische Auftragung hergestellt sind, wobei eine starre Platte wie aus Glas, Faserepoxy oder PET auf ihren beiden Seiten mit einem leitenden Metall, wie Kupfer oder flexiblem Aluminium, überzogen ist, wobei jede der Seiten eine Polarität aufweist.

4. Photovoltaikmodul (11) nach einem der vorhergehenden Ansprüche, **dadurch gekennzeichnet, dass** es einen elektrischen Anschluss durch mindestens ein leitendes Isolierband, das in der Dicke des Moduls angeordnet ist, umfasst.

5. Photovoltaikmodul (11) nach einem der vorhergehenden Ansprüche, **dadurch gekennzeichnet, dass** es mehrere Stecker mit positiver und negativer Polarität umfasst, die auf Höhe seines quadratischen Umfangs ohne aus dem Modul austretenden Draht angeordnet sind.

6. Photovoltaikvorrichtung, **dadurch gekennzeichnet, dass** sie mehrere Photovoltaikmodule (11) nach einem der vorhergehenden Ansprüche umfasst, die mechanisch und elektrisch verbunden sind.

7. Photovoltaikvorrichtung nach dem vorhergehenden Anspruch, **dadurch gekennzeichnet, dass** sie mehrere Photovoltaikmodule (11) umfasst, die in einer Einheit, die ein Rechteck oder ein Quadrat bildet, verbunden sind, und dass die Module in Serie oder parallel oder nach einer Matrixstruktur verbunden sind.

8. Photovoltaikanlage zur Erzeugung von Elektrizität, **dadurch gekennzeichnet, dass** sie mehrere Photovoltaikvorrichtungen nach Anspruch 6 oder 7 umfasst.

## Claims

1. Photovoltaic module (11) comprising a plurality of electrically connected photovoltaic cells (12), said module having a square shape and comprising at least two contact pads (17, 18) in each corner of the module, **characterized in that** it comprises at least four connectors (14, 15) on each edge (21; 22; 23; 24) of the module.

2. Photovoltaic module (11) according to the preceding claim, **characterized in that** it comprises an electrical connection via at least one conductor (25; 27) etched in insulating layers (26; 28) of the multilayer structure of the module, and at least one recess (35; 37) in order to allow contact with this at least one conductor (25; 27).

3. Photovoltaic module (11) according to Claim 1, **characterized in that** it comprises equipotential planes produced by electrochemical or electrolytic deposition, a rigid plate made of a material such as glass or epoxy fibre or PET being covered on both its sides with a conductive metal such as flexible aluminium or copper, each of these sides representing a polarity.

4. Photovoltaic module (11) according to one of the preceding claims, **characterized in that** it comprises an electrical connection via at least one insulated conductive strip located in the thickness of the module.

5. Photovoltaic module (11) according to one of the preceding claims, **characterized in that** it comprises a plurality of connectors of positive and negative polarity arranged around its square perimeter, with no wires running from the module.

6. Photovoltaic device, **characterized in that** it comprises a plurality of electrically and mechanically connected photovoltaic modules (11) according to one of the preceding claims.

7. Photovoltaic device according to the preceding claim, **characterized in that** it comprises a plurality of photovoltaic modules (11) connected in an array forming a rectangle or a square, and **in that** the modules are connected in series or in parallel or in a matrix structure.

8. Plant for producing photovoltaic electricity, **characterized in that** it comprises a plurality of photovoltaic devices according to either of Claims 6 and 7.
